# EUROPÄISCHE PATENTSCHRIFT

(11) **EP 1 286 131 B1**
(45) Veröffentlichungstag und Bekanntmachung des Hinweises auf die Patenterteilung: **29.03.2006**
(21) Anmeldenummer: 02102126.6
(22) Anmeldetag: 13.08.2002
(51) Int. Cl.: G01B 5/00, G01B 11/03, G01B 9/02, G03F 7/20

(54) **Koordinaten-Messtisch und Koordinaten-Messgerät**
Coordinate measuring table and coordinate measuring machine
Table de mesure de coordonnées et machine de mesure de coordonnées

(30) Priorität: 22.08.2001 DE 10140174
(43) Veröffentlichungstag der Anmeldung: 26.02.2003
(73) Patentinhaber: Leica Microsystems Semiconductor GmbH, 35578 Wetzlar (DE)
(72) Erfinder: Bläsing-Bangert, Carola, 35625, Hüttenberg (DE); Kaczynski, Ulrich, 61231, Bad Nauheim (DE)

(56) Entgegenhaltungen:
- EP-A- 1 014 030
- US-A- 4 676 649
- US-A- 5 574 556
- US-B1- 6 255 796

## Beschreibung

Die Erfindung betrifft einen Koordinaten-Messtisch mit den Merkmalen des Oberbegriffs des Anspruchs 1 sowie ein Koordinaten-Messgerät zur hochgenauen Messung der Koordinaten der Kanten eines Strukturelementes auf einem Substrat mit den Merkmalen des Oberbegriffs des Anspruchs 9.

Koordinaten-Messtische der eingangs genannten Art werden in hochgenauen Koordinaten-Messgeräten der eingangs genannten Art verwendet. Ein solches Koordinaten-Messgerät ist in dem Artikel "Maskenmetrologie mit der LEICA LMS IPRO für die Halbleiterproduktion" von K.-D. Röth und K. Rinn, Mitteilungen für Wissenschaft und Technik Bd. XI, Nr. 5, Seite 130-135, Oktober 1997, angegeben. Dieses Messgerät dient zur hochgenauen Messung der Koordinaten der Kanten eines Strukturelementes auf einem Substrat, z. B. einer Maske und einem Wafer.

Das Koordinaten-Messgerät weist einen Messtisch der eingangs genannten Art auf, der in der x-Richtung und der y- Richtung horizontal verschiebbar ist. Er dient zur Aufnahme der Substrate mit Strukturen, deren Kanten-Koordinaten vermessen werden sollen. Ferner ist jeder Koordinatenachse (x,y) des Messtischs ein separater Interferometer-Messstrahlengang zugeordnet. An zwei zueinander senkrecht stehenden Seiten des Messtischs sind Messspiegel angebracht, die sich an den Enden der beiden Interferometer-Messstrahlengänge befinden. Mittels der beiden Messspiegel kann die Position des Messtisches interferometrisch bestimmt werden.

Das Koordinaten-Messgerät besitzt weiterhin eine Auflicht-Beleuchtungseinrichtung mit einer optischen Achse, eine Abbildungseinrichtung (beispielsweise ein Mikro-Objektiv) und eine Detektor-Einrichtung (beispielsweise eine hochauflösende Digital-Kamera oder einen positionsempfindlichen Detektor) für die abgebildeten Strukturen. Die gemessenen Koordinaten einer zu vermessenden Kante einer Struktur ergeben sich aus der aktuellen, interferometrisch gemessenen Position des Messtischs und dem Abstand der zu messenden Struktur relativ zur optischen Achse. Damit geht die Positioniergenauigkeit, die bei der interferometrischen Messung der Messtisch-Position erfasst wird, direkt in die Bestimmung der Koordinaten der Kanten an den Strukturen auf den Substraten ein. Da die optische Antastung für ein optimales Messergebnis in einer genau definierten Fokusebene (der sogenannten Abbeschen Ebene) erfolgen muss, liefern Abweichungen in der Höhen-Ablaufgenauigkeit von dieser idealen Ebene ebenfalls Fehleranteile zu den Messergebnissen.

Koordinaten-Messgeräte der genannten Art dienen zur Bestimmung der Koordinaten mit einer Reproduzierbarkeit im Bereich von weniger als 5 nm. Da diese Messgenauigkeit ganz wesentlich von der xy-Positioniergenauigkeit und der Höhen-Ablaufgenauigkeit des Messtischs abhängt, werden extrem hohe Anforderungen an die Konstruktion des Messtischs gestellt.

Ein Koordinaten-Messtisch des oben beschriebenen Koordinaten-Messgeräts weist übereinander angeordnet folgende Elemente auf:
- ein feststehendes Basisteil mit einem linearen x-Führungselement,
- darüber ein entlang des linearen x-Führungselements gleitend bewegliches Mittelteil, dem ein erstes Antriebselement zugeordnet ist und das mit einem linearen y-Führungselement starr verbunden ist,
- darüber einen xy-positionierbaren, entlang des y-Führungselements gleitend beweglichen Tischkörper zur Aufnahme eines Substrates, dem ein zweites Antriebselement zugeordnet ist.

Das x-Führungselement ist auf der Mitte des Basisteils beispielsweise als eingelassene Nut ausgebildet, an dem das Mittelteil geführt wird. Das breit ausgebildete Mittelteil ist quer zu dem x-Führungselement angeordnet und bildet mit dem x-Führungselement ein bewegliches Kreuz. Diese Tischkonstruktion ist daher dem Fachmann unter der Bezeichnung "Kreuztisch" geläufig. Das Mittelteil trägt auf seiner Mittelachse das y-Führungselement und stützt sich zu beiden Seiten des x-Führungselements mit insgesamt drei Tragluftlagern auf die Oberfläche des Basisteils ab. Damit ist eine stabile Drei-Punktauflage gegeben.

Der Tischkörper wird in seiner Bewegung von dem y-Führungselement geführt und überspannt das Mittelteil. Dabei stützt er sich zu beiden Seiten des x-Führungselements mit insgesamt vier Tragluftlagern, also mit je zwei Tragluftlagern auf jeder Seite des x-Führungselements, auf die Oberfläche des Basisteils ab. Da eine Lagerung mit vier Auflageflächen überbestimmt ist, ist eines der vier Tragluftlager als federndes Tragluftlager ausgebildet, um Unebenheiten der Oberfläche des Basisteils auszugleichen.

Da die Koordinaten-Messmaschine zur Erzielung optimaler Messergebnisse in einer konstanten Umgebungstemperatur betrieben werden muss, wird sie in einer Klimakammer aufgestellt. In den einzelnen Fabriken werden in den Klimakammern unterschiedliche Umgebungstemperaturen gefordert. So werden die Geräte je nach gewählter Temperatur in einem Temperaturbereich zwischen 20 und 23 ° Celsius betrieben. Diese Temperaturunterschiede führen an den einzelnen Bauteilen der Koordinaten-Messmaschine zu unterschiedlichen Ausdehnungen der Materialien. Dies wiederum verändert die Luftspalte der Luftlager. Daher wurden auch eine Teil der Führungsluftlager federnd ausgelegt. So wurden an jedem Führungselement jeweils die Führungsluftlager einer Seite des Führungselementes federnd ausgelegt und die Führungsluftlager an der gegenüber liegenden Seite starr ausgelegt.

Sowohl die Tragluftlager als auch die Führungsluftlager wurden mit sehr kleinen Luftspalten (Größenordnung 3 bis 4 µm) ausgewählt. Die Anpassung an Unebenheiten der jeweiligen Führungsfläche wird durch die jeweils federnd gelagerten Trag- bzw. Führungsluftlager vorgenommen. Die engen Luftspalt-Höhen sind sehr toleranzempfindlich und müssen daher einjustiert werden.

Die federnden Luftlager haben sich in der Praxis jedoch als problematisch erwiesen, da sie ein geringes Kippen und damit ein Verwinden des Tischkörpers beim Verfahren des Messtisches und bei unterschiedlichen Substrat-Gewichten zulassen. Außerdem können sich die von der Unebenheit der Basisteil-Oberfläche verursachten Höhen-Ablauf-Ungenauigkeiten des Mittelteils über das y-Führungselement auf den Tischkörper übertragen. Dies führt zu einer Veränderung der interferometrischen Positionsmessung in Abhängigkeit von der angefahrenen xy-Position und hat damit direkt Auswirkungen auf die Messgenauigkeit.

Ein weiterer Nachteil dieses Messtischs besteht darin, dass keine Durchlich- Beleuchtung des Substrats möglich ist, da das Mittelteil mit dem y-Führungslineal in der Tischmitte verläuft. Außerdem ist der vorbekannte Messtisch nur für Substrate bis zu einer maximalen Größe von 220 mm geeignet. Eine Vergrößerung der einzelnen Elemente des Messtisches , zwecks Anpassung für größere Substrate, würde die Schwingungsproblematik nur verstärken.

Daneben ist aus US 4 676 649 ein Messtisch bekannt, bei dem über einem Basisteil ein Mittelteil und darüber ein Tischkörper angeordnet sind, wobei Tischkörper und Mittelteil jeweils auf Luftlagern gleitend geführt werden. Ein Messtisch mit Luftlagern und Öffnungen für Durchlicht ist in US 6 255 796 offenbart. Weiterhin ist in EP 1 014 030 ein Koordinatenmessgerät mit integriertem Messtisch und Auslegung für Durchlicht beschrieben. Bei allen genannten Vorrichtungen werden Interferometer zur Messung der Tischposition verwendet.

Es ist daher Aufgabe der vorliegenden Erfindung, einen Koordinaten-Messtisch anzugeben, der sowohl für Auflicht- als auch für Durchlicht-Messungen geeignet ist, der für zukünftige noch größere und schwerere Substrate (mit 300 mm Durchmesser und mehr) geeignet ist und zugleich eine deutlich verbesserte xy-Ablaufgenauigkeit und eine verbesserte Höhen-Ablaufgenauigkeit aufweist.

Diese Aufgabe wird gelöst durch einen Koordinaten-Messtisch mit interferometrischer Positionsbestimmung, der übereinander angeordnet folgende Elemente aufweist:
- ein feststehendes Basisteil mit einem linearen x-Führungselement,
- darüber ein entlang des linearen x-Führungselements gleitend bewegliches Mittelteil, dem ein erstes Antriebselement zugeordnet ist und das mit einem linearen y-Führungselement starr verbunden ist,
- darüber einen xy-positionierbaren, entlang des y-Führungselements gleitend beweglichen Tischkörper zur Aufnahme eines Substrates, dem ein zweites Antriebselement zugeordnet ist,
der sich erfindungsgemäß dadurch auszeichnet,
a) dass das Mittelteil über dem Basisteil frei hängend angeordnet ist, wobei es sich mit seinem einen Ende auf das y-Führungselement und mit seinem anderen Ende auf ein zusätzlich angeordnetes Tragelement abstützt,
b) dass das y-Führungselement, das Tragelement und der Tischkörper sich unabhängig von einander gleitbar auf die Oberfläche des Basisteils abstützen
c) und dass das Basisteil, das Mittelteil und der Tischkörper jeweils eine innenliegende Öffnung für einen Durchlichtbereich aufweisen.

Es ist eine weitere Aufgabe dieser Erfindung, ein Koordinaten-Messgerät zur hochgenauen Messung der Koordinaten der Kanten eines Strukturelementes auf einem Substrat anzugeben, das sowohl für Auflicht- als auch für Durchlicht-Messungen geeignet ist, für zukünftige noch größere und schwerere Substrate (mit 300 mm Durchmesser und mehr) geeignet ist und zugleich eine deutliche verbesserte xy-Positioniergenauigkeit und eine verbesserte Höhen-Ablaufgenauigkeit für das Substrat aufweist.

Diese Aufgabe wird gelöst durch ein Koordinaten-Messgerät zur hochgenauen Messung der Koordinaten einer Kante eines Strukturelementes auf einem Substrat mit
- einem xy-verfahrbaren Koordinaten-Messtisch mit interferometrischer Positionsbestimmung, der ein feststehendes Basisteil mit einem linearen x-Führungselement, darüber ein entlang des linearen x-Führungselements gleitend bewegliches Mittelteil und darüber einen xy-positionierbaren, entlang des y-Führungselements gleitend beweglichen Tischkörper zur Aufnahme des Substrats aufweist,
- sowie einer Beleuchtungseinrichtung mit einer optischen Achse, einer Abbildungseinrichtung und einer Detektor-Einrichtung zur Bestimmung der Koordinaten der zu messenden Kante relativ zur der optischen Achse der Beleuchtungseinrichtung,
welches sich erfindungsgemäß dadurch auszeichnet,
a) dass das Mittelteil über dem Basisteil frei hängend angeordnet ist, wobei es sich mit seinem einen Ende auf das y-Führungselement und mit seinem anderen Ende auf ein zusätzlich angeordnetes Tragelement abstützt,
b) dass das y-Führungselement, das Tragelement und der Tischkörper sich unabhängig von einander gleitbar auf die Oberfläche des Basisteils abstützen,
c) und dass das Basisteil, das Mittelteil und der Tischkörper des Messtischs jeweils eine innenliegende Öffnung für einen Durchlichtbereich aufweisen und die Beleuchtungseinrichtung für Auf-und Durchlicht-Beleuchtung des Substrates vorgesehen ist.

Zur Lösung der gestellten Aufgabe reichte es nicht aus, die übereinander angeordneten Elemente Basisteil, Mittelteil und Tischkörper an die großen Substrate anzupassen und sie nur entsprechend zu vergrößern, denn durch den geforderten deutlich vergrößerten Verfahrbereich wurde der Messtisch sehr groß und schwer und die Schwingungsprobleme nur vergrößert. Dadurch wurde zunächst eine extreme Instabilität der Konstruktion und eine verringerte Höhen-Ablaufgenauigkeit erzeugt. Außerdem war wegen der erforderlichen Führungselemente für die x- und die y-Richtung kein Durchlichtaufbau realisierbar. Es musste also ein grundsätzlich anderer Ansatz zur Lösung der Aufgabe verfolgt werden.

Die Idee der Erfindung besteht wesentlich darin, die Toleranzkette bei der neuen Konstruktion deutlich zu verringern. Das heißt beispielsweise, dass die Summe aller mechanischen Toleranzen in z-Richtung, also in Richtung der Höhe des Tisches, verringert werden mussten. Dazu mussten in z-Richtung die Toleranzen an den einzelnen, mechanisch miteinander verbundenen Teilen bei der Konstruktion berechnet, fertigungstechnisch berücksichtigt und so verringert werden, dass eine extrem gute Ablaufgenauigkeit des Tisches in der xy-Ebene erzielt wurde.

Die Lösung hierzu lieferte eine komplette Änderung des mechanischen Konzepts des Tischaufbaus, wobei von dem Konzept des "Kreuztischs" vollständig abgewichen wurde. So stellte bei dem Koordinaten-Messtisch nach dem Stand der Technik das Mittelteil ein tragendes Teil dar und trug auf seiner Längs-Symmetrieachse das y-Führungselement. Im Gegensatz dazu wurde in dem erfindungsgemäßen Messtisch das y-Führungselement zum tragenden Element und das Mittelteil zum getragenen Element umgebildet. Dazu wurde das y-Führungselement aus der Symmetrieachse des Mittelteils entfernt und an dem einen Ende des Mittelteils als tragendes Teil angeordnet. Das andere Ende des Mittelteils wurde an einem zusätzlichen Tragelement aufgehängt. Auf diese Weise wurde das Mittelteil hängend angeordnet, wobei es durch das y-Führungselement und das zusätzlich angeordnete Tragelement getragen wird.

Diese hängende Mittelteil bot nun erstmals auch die Möglichkeit, einen Durchlichtaufbau zu realisieren, da das y-Führungselement stets weit von der Mitte des Mittelteils entfernt und damit außerhalb der Messtischmitte angeordnet ist. Daher wurden das Basisteil, das Mittelteil und der Tischkörper mit rahmenförmigen Öffnungen versehen, um auf diese Weise einen Durchlichtbereich zu schaffen.

Das y-Führungselement und das Tragelement liegen mit Tragluftlagern auf der Oberfläche des Basisteils auf. Das y-Führungselement wurde sehr lang und das Tragelement möglichst kurz dimensioniert. Zusätzlich wurde das Mittelteil in x-Richtung und damit der Abstand zwischen dem y-Führungselement und dem Tragelement möglichst groß gewählt, wodurch die Luftlager in großem Abstand zu einander angeordnet werden konnten. Dadurch konnte eine große Ablaufstabilität des Messtisches ohne Kippneigung erreicht werden. Zugleich bot das lange Mittelteil die Möglichkeit, die rahmenförmige Öffnung in x-Richtung möglichst groß zu gestalten.

Bei dem Koordinaten-Messtisch aus dem Stand der Technik musste ein komplizierte Toleranzkette der einzelnen Bauelemente des Koordinaten-Messtisches berücksichtigt werden. So gingen beispielsweise die Oberflächen-Ebenheiten von Tischkörper, Mittelteil und Basisteil, die Maßhaltigkeit des y-Führungselementes auf dem Mittelteil, die Toleranzen der jeweiligen Tragluftlager (Flughöhen, Ebenheiten der Montageflächen) und die Justier-Genauigkeit der Führungsluftlager in die Toleranzrechnung ein. Dabei mussten für jedes einzelne Bauelement mehrere Toleranzen (in der Regel drei und mehr) bezüglich Form, Lage und Maß eingehalten werden. Trotzdem mussten noch die Luftspalte der Führungsluftlager einzeln justiert werden. Jedes toleranzempfindliche Teil führte auch zu höheren Fertigungskosten.

Statt dessen ist bei dem erfindungsgemäßen Koordinaten-Messtisch die Bezugsebene für die Toleranzrechnung die plane Oberfläche des Basisteils. Der Tischkörper stützt sich mittels ungefederter Tragluftlager gleitend auf dem Basisteil ab. Seine Toleranzen sind auf dieselbe Bezugsebene, nämlich die plane Oberfläche des Basisteils, bezogen. Die einzelnen Bauteile des erfindungsgemäßen Koordinaten-Messtisches, wie beispielsweise das Mittelteil, der Tischkörper, das y-Führungselement und das y-Lineal , müssen nur noch ein bis zwei Toleranzen bezüglich Form, Lage und Maß einhalten. Beispielsweise muss lediglich die Unterseite des Tischkörpers, an der die Tragluftlager angeordnet werden, hocheben ausgebildet sein. Die Ebenheit der Oberfläche des Basisteils bestimmt die gesamte Höhen-Ablaufgenauigkeit (Abweichungen von der idealen z-Ebene) des erfindungsgemäßen Koordinaten-Messtischs.

Die Luftspaltabstände der Tragluftlager und der Führungstuftlager sind durch die angrenzenden Bauteile fest vorgegeben, so dass die Luftspalte der Tragluftlager und der Führungsluftlager nicht mehr justiert werden müssen und die Konstruktion insgesamt steifer und damit weniger schwingungsanfällig als bei dem vorbekannten Koordinaten-Messtisch ist. Damit wird bei dem erfindungsgemäßen Messtisch die Ablaufgenauigkeit und die Positioniergenauigkeit wesentlich verbessert. Dies wiederum verbessert die Messgenauigkeit des Koordinaten-Messgeräts, in dem der Koordinaten-Messtisch zur Aufnahme des zu vermessenden Substrats angeordnet ist.

Das Basisteil besteht in der Regel aus Granit. Aus Gründen der Schwingungsdämpfung wird ein großer Granitblock verwendet, der auf Schwingungsdämpfern gelagert ist. Das y- Führungselement und das Tragelement sowie der Tischkörper stützen sich über ihre ebenen Unterseiten mittels Tragluftlagern auf der Oberfläche des Basisteils (Granit) ab. Alle Tragluftlager werden mit gleicher Dicke gewählt, wobei die absolute Dickentoleranz der Tragluftlager in der Größenordnung von ca. 2 µm liegt. Dies ist für die Lagerhaltung und den Service vorteilhaft, da beim Austausch eines beschädigten Lagers keine Justierarbeiten notwendig sind. Da die verwendeten Tragluftlager alle gleich sind, wird die Teilevielfalt reduziert und es sind keine individuell angefertigten Lager erforderlich. Bei den Tragluftlagern ist lediglich eine ausreichende Flughöhe (= Luftschicht) erforderlich.

Auch bei den Führungsluftlagern wurde auf die federnde Lagerung vollkommen verzichtet. Die Führungsluftlager sind dickentoleranz-unabhängig. Lediglich die Anschraubfläche und die Lauffläche, aus der die Luft ausströmt, müssen exakt in einer Ebene liegen. Dies wird durch gemeinsames Läppen der Anschraubfläche und der Lauffläche erreicht. Eine Justage der Führungsluftlager entfällt, da die Breite Luftspalte durch die angrenzenden Bauteile fest vorgegeben sind.

Als besonders vorteilhaft erweist sich eine Ausführungsform des Koordinaten-Messtischs, bei dem die x-Führung und die y-Führung temperatur-kompensiert ausgebildet sind. Dazu werden diejenigen Bauteile des Koordinaten-Messtischs, an denen die Führungslager für das x-Führungselement bzw. das y-Führungselement befestigt sind, in Bezug auf das x-Führungselement bzw. das y-Führungselement temperatur-kompensiert. Dies ist wichtig, da die Breite der Bauteile des Koordinaten-Messtischs, an denen die Führungslager befestigt sind, den Abstand der ihr zugewendeten Montageflächen der Luftlager bestimmt und damit unmittelbar die Breite der erzeugten, führenden Luftschichten (und damit der Führungseigenschaften) beeinflusst.

Zur Temperatur-Kompensation der Bauteile, an denen die Führungslager befestigt sind, werden sie aus demselben Material gewählt, wie das Material der eingelassenen Nuten oder erhabenen Schienen (je nach Ausführungsform) des x-Führungselements bzw. des y-Führungselements, an denen die Führungsluftlager mit den erzeugten Luftspalten die Führung erzeugen. Damit zusätzlich die x- und y-Führung kein unterschiedliches Ausdehnungsverhalten aufweisen, wurden auch die beiden Führungselemente (für x und y) aus dem gleichen Material gewählt. Da das Basisteil und damit das x-Führungselement aus Granit bestehen, folgte daraus, dass auch das y- Führungselement aus Granit ausgebildet wurde.

Daher wurden auch die Bauteile, an denen die Führungslager befestigt sind, aus Granit gefertigt. Zusätzlich werden diese Bauteile so dimensioniert, dass sie nur um die beiden führenden Luftschichten schmaler sind als die Nuten bzw. dass sie um die beiden führenden Luftschichten breiter sind als die Schienen selbst.

Auf diese Weise wird erreicht, dass diese Bauteile, an denen die Führungslager befestigt sind, exakt den gleichen Ausdehnungskoeffizienten aufweisen wie die Nuten oder Schienen (je nach Ausführungsform) des x-Führungselements bzw. des y-Führungselements. Dadurch ist auch bei unterschiedlichen Umgebungstemperaturen des Koordinaten-Messtischs sichergestellt, dass die für die Führung vorgegebenen Luftspalte der Führungsluftlager immer unverändert bleiben. Dies führt zu einer deutlichen Steigerung der Führungsgenauigkeit gegenüber vorbekannten Führungskonstruktionen.

In einer vorteilhaften Ausführungsform des Messtisches wurde die Höhen-Ablaufgenauigkeit noch weiter verbessert, indem die Antriebselemente für die x-Richtung und die y-Richtung relativ zu dem Basisteil feststehend angeordnet wurden. Dazu erfolgt die Kraftübertragung auf das in x-Richtung bewegliche Mittelteil und den in y-Richtung beweglichen Tischkörper beispielsweise mittels je mindestens einer Schubstange, die über eine Reibkupplung mit dem jeweiligen Motor verbunden sind. Auf diese Weise wird erreicht, dass die Höhen-Ablaufgenauigkeit und Positioniergenauigkeit des Koordinaten-Messtischs über den gesamten Verfahrbereich konstant ist.

Dies ist ein deutlicher Vorteil gegenüber den vorbekannten Koordinaten-Messtischen, bei denen einer der Motoren mitbewegt wurde. Bei diesen führte das Gewicht des mitbewegten Motors selbst bereits beim unbeladenen Tischkörper zu Deformationen des gesamten Messtischs und damit zur Beeinträchtigung der Positioniergenauigkeit in Abhängigkeit von der xy-Position. Außerdem wird die Kabelzuführung zu den Motoren vereinfacht, da die Kabel nicht mehr mitbewegt werden müssen, was zum einen den Verschleiß der Kabel und zum anderen die Erschütterungen des Koordinaten-Messtischs verringert. Da der Positionier-Fehler bei dem vorbekannten Koordinaten-Messtisch nicht konstant, sondern abhängig vom Messort und zusätzlich abhängig von dem Gewicht des aufgelegten Substrates war, konnte der Positionier-Fehler auch nicht rechnerisch aus den gemessenen Koordinaten einer Kante eliminiert werden.

Demgegenüber weist der erfindungsgemäße Koordinaten-Messtisch mit den feststehenden Antriebselementen für alle anfahrbaren xy-Positionen einen vom Verfahrweg unabhängigen Positionier-Fehlerwert auf, der rechnerisch und messtechnisch erfasst werden kann. Zusätzlich wird das jeweils aufgelegte Gewicht konstant gehalten. Dazu wird ein zu vermessendes Substrat für die Durchlichtmessung jeweils in einem speziell zugeordneten Rahmen eingelegt und gemeinsam mit dem Rahmen auf den Tischkörper aufgelegt. Dabei wird für die verschiedenen Substrate die Summe aus dem Gewicht des jeweiligen Substrats und dem Gewicht des dazu gehörigen Rahmens konstant gehalten. Damit kann auch für diesen Positionier-Fehterwert eine Fehlerkorrektur bei der Berechnung der Koordinaten von zu vermessenden Strukturen vorgenommen werden.

Die Erfindung wird nachfolgend anhand der schematischen Zeichnungen erläutert. Es zeigen:
- ***Fig. 1:***: eine Aufsicht auf einen Koordinaten-Messtisch nach dem Stand der Technik;
- ***Fig. 2:***: eine Explosionsdarstellung eines erfindungsgemäßen Koordinaten-Messtisches;
- ***Fig. 3:***: eine Detaildarstellung des Mittelteils des Koordinaten-Messtisches;
- ***Fig. 4:***: eine räumliche Ansicht eines erfindungsgemäßen Koordinaten-Messtischs;
- ***Fig. 5:***: ein erfindungsgemäßes Koordinaten-Messgerät.

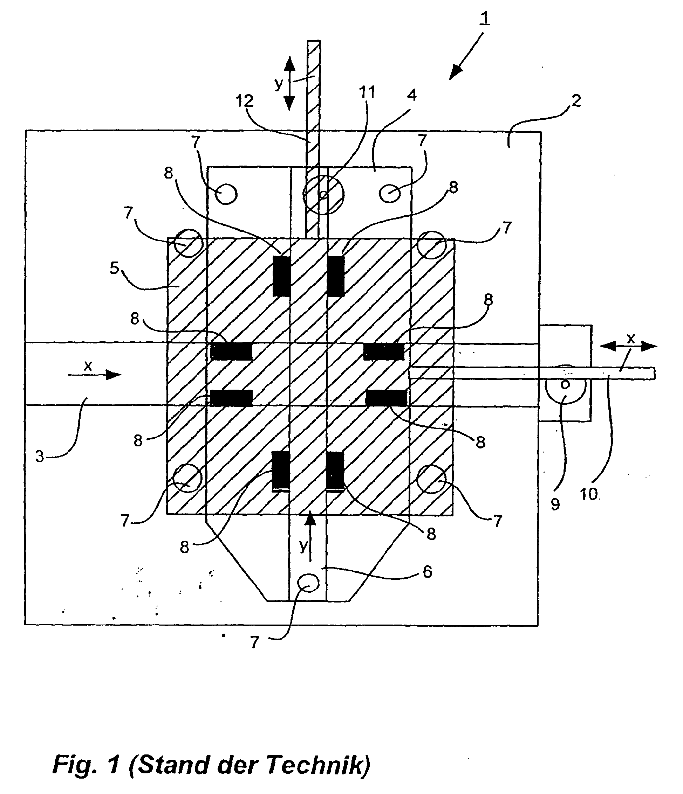

In ***Fig. 1*** ist schematisch der aus dem Stand der Technik vorbekannte Koordinaten-Messtisch 1, der in dem vorbekannten Koordinaten-Messgerät verwendet wird, in der Aufsicht dargestellt. An einem Basisteil 2 ist ein x-Führungselement 3 als eingelassene Nut angeordnet. Das Basisteil 2 selbst ist feststehend, besitzt jedoch eine plane Oberfläche, die als Gleitfläche für die bewegten Elemente des Messtischs 1 dient. Die bewegten Teile sind ein über dem Basisteil 2 angeordnetes Mittelteil 4 und ein darüber angeordneter Tischkörper 5. Das Mittelteil 4 ist orthogonal zu dem x-Führungselement 3 angeordnet und erstreckt sich über den größten Teil der Länge des Basisteils 2. Das Mittelteil 4 trägt an seiner Oberseite mittig angeordnet in Längsrichtung ein y-Führungselement 6, das in der Regel als aufgesetzte Schiene angeordnet ist. Das Mittelteil 4 selbst ist in x-Richtung beweglich, da es mit seiner Unterseite mittels Führungsluftlagern 8 in das x-Führungselement 3 eingreift. Die Lagerung auf dem Basisteil 2 während der Bewegung erfolgt mittels drei Tragluftlagern 7.

Die Verschiebung des Mittelteils 4 entlang des x-Führungselements 3 erfolgt mittels eines ersten Antriebselements 9. Dessen Drehbewegung wird mittels einer ersten Schubstange 10, die längs in dem als Nut ausgebildeten x-Führungselement 3 verläuft, in eine Linearbewegung des Mittelteils 4 umgesetzt.

An dem einem Ende des Mittelteils 4 ist auf seiner Oberseite ein zweites Antriebselement 11 aufgesetzt. Dieses wird bei der Bewegung des Mittelteils 4 mitbewegt. Die Drehbewegung des zweiten Antriebselements 11 wird mittels einer zweiten Schubstange 12 in eine Linearbewegung umgesetzt und auf den über dem Mittelteil 4 angeordneten Tischkörper 5 übertragen. Der Tischkörper 5 greift zu beiden Längsseiten des Mittelteils 4 über das Mittelteil 4 hinweg und ist auf vier Tragluftlagern 7 auf der Oberfläche des Basisteils gleitend gelagert. Da die Lagerung mit vier Auflageflächen überbestimmt ist, sind die vier Lagerelemente federnd gelagert. Der Tischkörper 5 wird durch das zweite Antriebselement 11 in y-Richtung verschoben, wobei er durch das y-Führungselement 6 geführt wird. Die Lagerung gegenüber dem y-Führungselement 6 erfolgt wiederum mittels Führungsluftlagern 8.

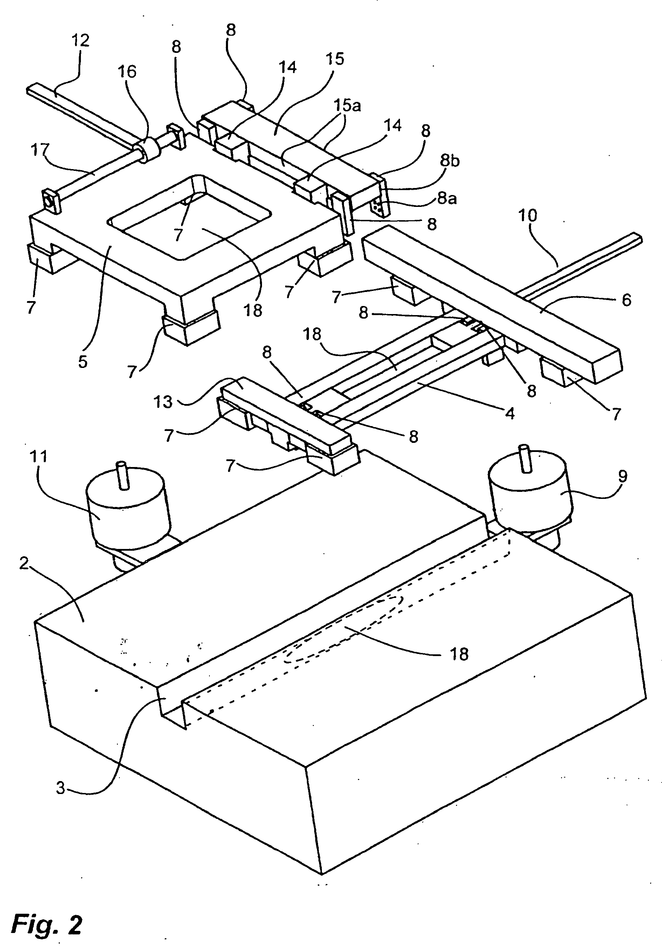

***Fig. 2*** zeigt eine Explosionsdarstellung eines erfindungsgemäßen Koordinaten-Messtisches 1. Dargestellt ist ein Basisteil 2, das vorzugsweise aus einem Granitblock besteht. Das Basisteil 2 ist mit einem x-Führungselement 3 ausgestattet, das in diesem Ausführungsbeispiel als eine innen liegende Nut an der Oberfläche des Basisteils 2 ausgebildet ist. Die Nut weist als Führungsflächen exakt parallele Außenflächen auf, die auf µm-Genauigkeit eben gearbeitet sind. Es wäre auch möglich, das x-Führungselement als erhabene Schiene auf der Oberfläche des Basisteils auszubilden. Allerdings würde dadurch der gesamte Aufbau des Koordinaten- Messtischs wesentlich höher und schwerer als mit einer Nut. Darüber angeordnet ist ein Mittelteil 4 und darüber, etwas seitlich versetzt, ein Tischkörper 5.

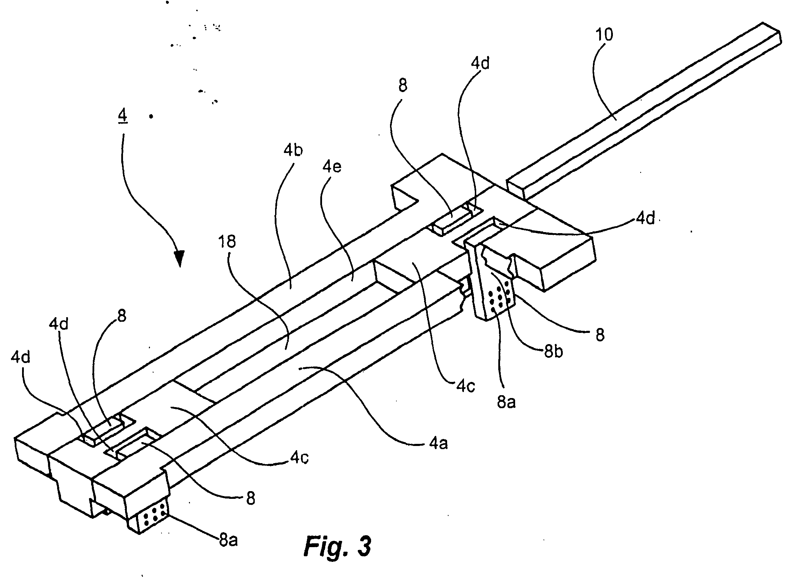

Das Mittelteil 4 ist oberhalb des Basisteils 2 frei hängend angeordnet, in dem es an einem y-Führungselement 6 und einem zusätzlichen Tragelement 13 aufgehängt ist. An der Unterseite des y-Führungselements 6 und des zusätzlichen Tragelements 13 sind Tragluftlager 7 angeordnet, mit denen sich die brückenförmige Einheit aus zusätzlichem Tragelement 13, dem Mittelteil 4 und dem y-Führungselement 6 gleitend auf dem Basisteil 2 abstützt. Um eine hohe Verkippungssicherheit zu erzielen, wurden das zusätzliche Tragelement 13 und das y-Führungselement 6 möglichst lang ausgelegt. Dadurch konnten die darunter befindlichen Tragluftlager 7 jeweils in möglichst großem Abstand angeordnet werden, jedoch so, dass die Durchbiegung durch Eigengewicht des Tragelements 13 bzw. des y-Führungselements 6 jeweils minimal, d.h. fast Null, wurde. Die Details des Aufbaus des Mittelteils 4 werden in ***Fig. 3*** beschrieben.

An dem frei hängendem Mittelteil 4 sind mehrere Führungsluftlager 8 angeordnet (hier teilweise verdeckt), welche nach unten weit über die Abmessungen des Mittelteils 4 hinausragen und in das x-Führungselement 3 (hier als Nut ausgebildet) eingreifen. Diese Führungsluftlager 8 bewirken eine exakte Führung der x-Bewegung des Mittelteils 4 entlang des x-Führungselements 3. Der Antrieb dieser Bewegung erfolgt mit einem ersten Antriebselement 9, das ortsfest an dem Basisteil 2 angeordnet ist. Die Drehbewegung dieses Antriebselementes 9, das beispielsweise als ein Schrittmotor oder ein Linearmotor ausgebildet sein kann, wird mittels einer ersten Schubstange 10 auf das Mittelteil 4 übertragen. Das Mittelteil 4 überspannt in y-Richtung nur wenig mehr als die Breite des x-Führungselements 3, da an ihm lediglich die Führungsluftlager 8 für die x-Führung befestigt werden müssen. Zu beiden Seiten des schmalen Mittelteils 4 besteht ein großer freier Verfahrbereich, in dem sich der Tischkörper 5 beim Verfahren in der x- und der y-Richtung auf der Oberfläche des Basisteils 2 abstützt.

Der Tischkörper 5 weist an seiner dem y-Führungselement 6 zugewandten Außenseite zwei Halteelemente 14 auf. An diesen Halteelemente 14 ist ein y-Lineal 15 befestigt. Dieses y-Lineal 15 überspannt in seiner Länge und Breite das y-Führungselement 6 und ist in montiertem Zustand des Koordinaten-Messtisches 1 über diesem y-Führungselement 6 angeordnet.

Das y-Lineal 15 weist in Längsrichtung an seinen beiden seitlichen Außenflächen gemeinsame hochebene Montageflächen 15a für sowohl die Halteelemente 14 als auch für mehrere Führungsluftlager 8 auf. An den Führungsluftlagern 8 werden durch Austrittsöffnungen 8a Luftpolster erzeugt, welche an den Außenseiten des y-Führungselements 6, welches als Führungsschiene wirkt, angreifen. Dazu sind die Außenflächen des y-Führungselements 6 und des y-Lineals 15 hochgenau parallel gearbeitet.

Das y-Lineal 15 ist um genau die beiden Luftlager-Luftspalte der beidseits angeordneten Führungsluftlager 8 breiter als das y-Führungselement 6. Das y-Führungselement 6 als auch das y-Lineal 15 sind aus demselben Material, vorzugsweise Granit, hergestellt, um dieselben thermischen Ausdehnungseigenschaften zu gewährteisten. Damit bewirken die Führungsluftlager 8 an dem y-Lineal 15 eine präzise, temperatur-kompensierte y-Führung des Tischkörpers 5.

Diese Bewegung wird erzeugt durch ein zweites Antriebselement 11, das ortsfest an dem Basisteil 2 angeordnet ist. Die Drehbewegung des zweiten Antriebselements 11 wird mittels einer zweiten Schubstange 12 auf den Tischkörper 5 übertragen. Das zweite Antriebselement kann beispielsweise als Schrittmotor oder Linearmotor ausgebildet sein. Da diese Kraftübertragung mittels der zweiten Schubstange 12 für alle beliebigen x-Positionen des Tischkörpers 5 gewährleistet sein muss, greift die zweite Schubstange 12 mittels eines Ringluftlagers 16 an einer in x-Richtung verlaufenden Schubstange 17, die hier zylindrisch ausgebildet ist, an.

Alle Tragluftlager 7 werden an den geläppten Flächen der Unterseiten des Mittelteils 4 und des Tischkörpers 5 befestigt. Damit soll das Verdrehen und Verkippen der Tragluftlager 7 verhindert werden. Um mehr Spielraum für Toleranzen der Führungsflächen zu haben, wird die Flughöhe der Tragluftlager 7 auf ca. 5 µm ausgelegt. Es gibt keine federnden Tragluftlager 7 wie beim Stand der Technik, sondern die Unebenheiten der Granitoberfläche werden durch den im Vergleich größeren Luftspalt ausgeglichen. Der gleiche Luftspalt wird an dem x-Führungselement 3 und dem y-Führungselement 6 verwendet.

Die einzelnen Bauteile des erfindungsgemäßen Koordinaten-Messtisches 1, wie beispielsweise das Mittelteil 4, der Tischkörper 5, das y-Führungselement 6 und das y-Lineal 15, müssen nur noch ein bis zwei Toleranzen bezüglich Form, Lage und Maß einhalten werden. So benötigt zum Beispiel das y-Lineal 15 nur zwei hochgenaue parallele Außenflächen zur Aufnahme der Führungsluftlager 8 und eine hochgenaue Maßtoleranz für den Abstand dieser beiden Außenflächen. Bei dem Tischkörper 5 müssen beispielweise lediglich seine Unterflächen, an welchen die Tragluftlager 7 befestigt werden, hochgenau auf einer geläppten Ebene liegen. Als zweite Toleranzgröße muss diejenige Außenfläche des Tischkörpers 5 , an welcher die Halteelemente 14 befestigt werden, hochgenau im rechten Winkel zu der geläppten Ebene der Unterflächen sein.

Diejenigen Bauteile des Koordinaten-Messtischs, die bei thermischer Ausdehnung zu Winkelfehlern führen könnten sind aus einem Material mit geringer thermischer Ausdehnung gefertigt, z. B. aus INVAR Stahl. Hierbei handelt es sich um das Mittelteil 4, das Tragelement 13 und der Tischkörper 5. Dadurch können thermische Einflüsse der Umgebung auf die Messergebnisse minimiert werden. Das y-Führungselement ist, wie bereits oben beschrieben, aus Granit, da dies für die beschriebene Temperatur-Kompensation der x- und der y-Führung erforderlich ist.

Um mit dem Koordinaten-Messtisch 1 Durchlichtmessungen durchführen zu können, weisen erfindungsgemäß das Basisteil 2, das Mittelteil 4 und der Tischkörper 5 jeweils eine innen liegende Öffnung 18 auf. Dabei ist die innen liegende Öffnung 18 im Basisteil 2 am kleinsten und an dem Mittelteil 4 und dem Tischkörper 5 entsprechend ihren Verfahrbereichen größer ausgebildet.

**Fig. 3** zeigt eine Detaildarstellung des Mittelteils 4 des Koordinaten-Messtisches 1. Dargestellt ist das Mittelteil 4 mit den daran angeordneten Führungsluftlagern 8.

Das freihängende Mittelteil 4 ist hier ohne das y-Führungselement 6 und das zusätzliche Tragelement 13, an denen es aufgehängt ist, dargestellt. Das Mittelteil 4 besteht aus zwei Mittelteil-Seitenelementen 4a, 4b, die mit mindestens einem Abstandselement 4c miteinander verbunden sind. Im vorliegenden Ausführungsbeispiel sind zwei Abstandelemente 4c zwischen den beiden Mittelteil-Seitenelementen 4a, 4b angeordnet. Die Abstandselemente 4c berühren nicht das Basisteil 2 (hier nicht dargestellt) und sind damit ebenfalls freihängend. Die Abstandselemente 4c weisen Aussparungen 4d auf, welche die Freiräume zur Anordnung der Führungsluftlager 8 bilden. Die Führungsluftlager 8 sind mit hochebenen Montageflächen 8b an dafür vorgesehenen, ebenfalls hochebenen Montageflächen 4f der Mittelteil-Seitenelemente 4a, 4b befestigt, ohne das jeweils daneben befindliche Abstandselement 4c zu berühren.

Zur Verdeutlichung der Anordnung der Führungsluftlager 8 ist in der Darstellung das Mittelteil-Seitenelement 4a an einem der Führungsluftlager 8 in geöffnetem Zustand dargestellt. Man erkennt, dass das Führungsluftlager 8 in einer innen liegenden Aussparung 4d des Abstandselementes 4c angeordnet ist und nach unten weit über die untere Abmessung des Mittelteils 4 hinausragt. An der Außenseite des nach unten überstehenden Anteils des Führungsluftlagers 8 sind die Austrittsöffnungen 8a des eigentlichen Luftlagers angeordnet.

Mit diesem nach unten überstehenden Anteil des Führungsluftlagers 8 bzw. aller Führungstuftlager 8 greifen diese Führungsluftlager in das als Nut ausgebildete x-Führungselement 3 (hier nicht dargestellt) des Basisteils 2 (hier nicht dargestellt) ein. Dabei weisen die Austrittsöffnungen 8a in Richtung der Innenseiten der Nut, als welche das x-Führungselement 3 ausgebildet ist. Zur Vervollständigung des Darstellung ist die erste Schubstange 10 mit dargestellt.

Das Mittelteil 4 ist Bestandteil eines Koordinaten-Messtischs 1 für ein hochpräzises Koordinaten-Messgerät, das (wie bereits gesagt) in verschiedenen Umgebungstemperaturen betrieben wird. Daher sollte die gesamte Führung in den beiden Richtungen x und y temperatur-kompensiert sein. Dies wurde hier dadurch erreicht, dass die Abstandselemente 4c aus Granit gefertigt sind und daher denselben Ausdehnungskoeffizienten aufweisen wie das x-Führungselement 3, das ebenfalls aus Granit ist. Die Abstandselemente 4c sind um die beiden Luftspalte schmaler als die Innenbreite der Nut, d.h. des x- Führungselementes 3. Damit gibt die Breite der Abstandselemente 4c die Breite der Luftspalte der Führungsluftlager 8 fest vor. Indem die temperaturbedingte Ausdehnung der Abstandselemente 4c stets gleich derjenigen der Nut ist, ist sichergestellt, dass die Breite der Luftspalte der Führungsluftlager 8 stets unveränderlich bleibt. Damit ist die Genauigkeit der Führung in x-Richtung unabhängig von der Umgebungstemperatur.

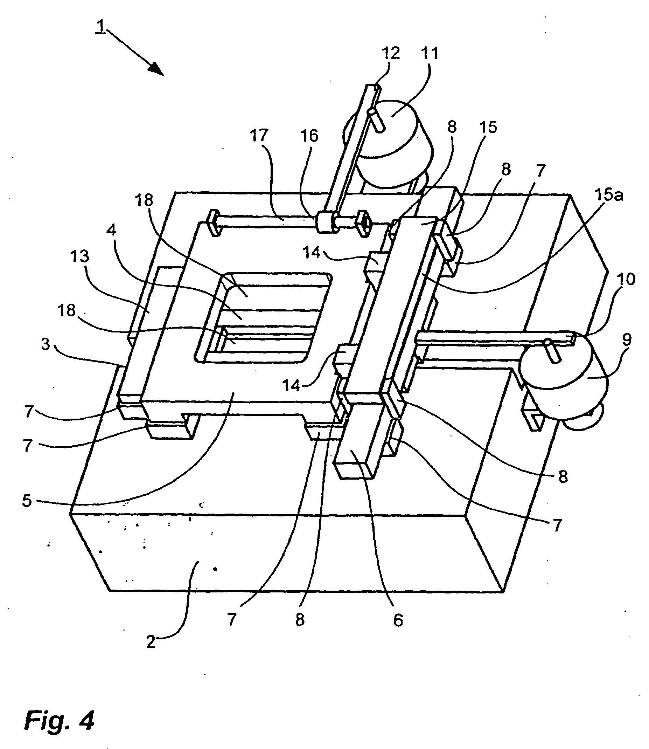

**Fig. 4** zeigt eine räumliche Ansicht eines komplett montierten erfindungsgemäßen Koordinaten-Messtischs 1. Dargestellt ist ein Basisteil 2 mit einem darüber angeordneten Mittelteil 4. Das Mittelteil 4 ist aufgehängt an einem y-Führungselement 6 und einem zusätzlichen Tragelement 13, welche sich beide mittels Tragluftlagern 7 auf der planen Oberfläche des Basisteils 2 abstützen und darauf gleitend verschiebbar sind. Zur Verschiebung des Mittelteils 4 in x-Richtung weist das Basisteil 2 ein als Nut ausgebildetes x-Führungselement 3 auf. Die an dem Mittelteil 4 angeordneten Führungsluftlager 8, welche zur Führung der Bewegung in x-Richtung in das x-Führungselement 3 eingreifen, sind in dieser Darstellung verdeckt. Zur Erzielung der x-Bewegung ist das Mittelteil 4 mit einer ersten Schubstange 10 verbunden, welche die Drehbewegung eines ersten Antriebselementes 9 auf das Mittelteil 4 überträgt.

Oberhalb des Mittelteils 4 ist der Tischkörper 5 angeordnet, welcher das Mittelteil 4 weit überspannt. Der Tischkörper 5 stützt sich mittels mehrerer Tragluftlager 7 ebenfalls auf die Oberfläche des Basisteils 2 ab und ist gleitend in y-Richtung entlang eines y-Führungselements 6 verschiebbar. Da dieses y-Führungselement 6 das in x-Richtung bewegliche Mittelteil 4 trägt, folgt der Tischkörper 5 zwangsgeführt jeder Bewegung des Mittelteils 4 in x-Richtung.

An der dem y-Führungselement 6 zugewandten Außenseite des Tischkörpers 5 sind zwei Halteelemente 14 angeordnet, an denen ein y-Lineal 15 befestigt ist. An dem y-Lineal 15 sind außenseitig mehrere Führungsluftlager 8 angeordnet, welche gegen die Außenseite des y-Führungselements 6 gelagert sind und eine präzise Bewegung des Tischkörpers 5 entlang des y-Führungselementes 6 sicherstellen. Zur Erzielung der y-Bewegung ist an dem Basisteil 2 ortsfest ein zweites Antriebselement 11 angeordnet, dessen Drehbewegung mit einer zweiten Schubstange 12 auf den Tischkörper 5 übertragen wird. Dazu greift die zweite Schubstange 12 an ihrem einen Ende mit einem Ringluftlager 16 an einer in x-Richtung verlaufenden Schubstange 17 an.

Das Basisteil 2, das Mittelteil 4 und der Tischkörper 5 weisen übereinanderliegend jeweils eine innen liegende Öffnung 18 auf, welche einen Durchlichtbereich für Durchlichtmessungen freihalten.

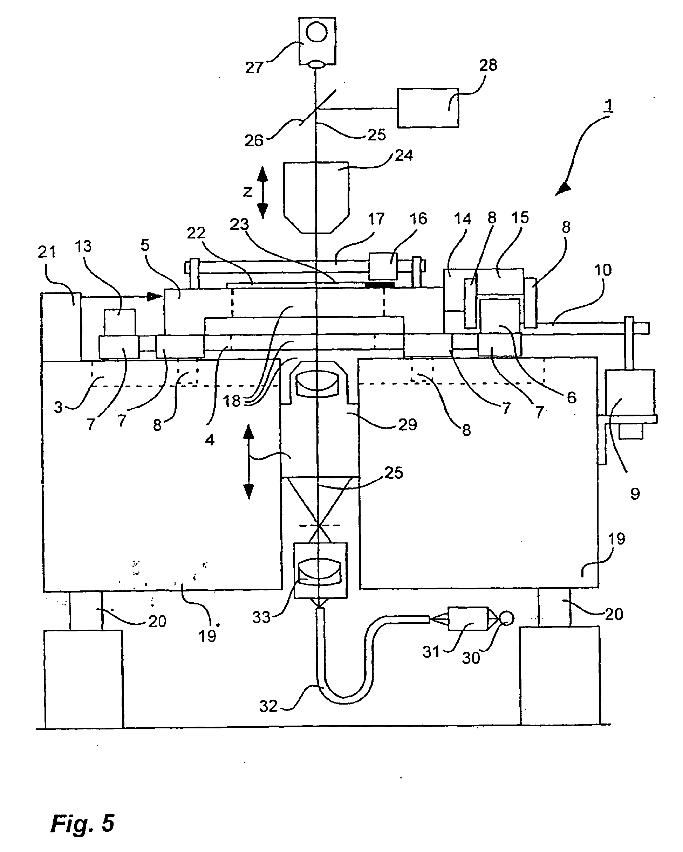

**Fig. 5** zeigt ein Ausführungsbeispiel für ein erfindungsgemäßes Koordinaten- Messgerät mit einer kombinierten Auflicht- und Durchlicht-Beleuchtung.

Das dargestellte Koordinaten-Messgerät weist einen Granitblock 19 auf, der auf Schwingungsdämpfern 20 gelagert ist und das Basisteil (entsprechend dem Basisteil 2 aus Fig. 2 - 4) eines Koordinaten-Messtischs 1 bildet. Dazu weist der Granitblock 19 an seiner Oberseite als x- Führungselement 3 eine eingelassene Nut (gestrichelt dargestellt) in x-Richtung auf und eine innenliegende Öffnung 18 auf.

Oberhalb des Granitblocks 19 ist ein Mittelteil 4 des Koordinaten-Messtischs 1 freihängend angeordnet, das eine innenliegende Öffnung 18 aufweist. Das Mittelteil 4 ist an einem y-Führungselement 6 und einem zusätzlichen Tragelement 13 aufgehängt. Das y-Führungselement 6 und das zusätzliche Tragelement 13 sind mittels Tragluftlagern 7 auf der Oberfläche des hochgenau ebenen Granitblocks 19 gleitend verschiebbar. Um eine sichere Führung des Mittelteils 4 in x-Richtung zu gewährleisten, sind an dem Mittelteil 4 mehrere Führungsluftlager 8 (gestrichelt dargestellt) angebracht, welche in das x-Führungselement 3 (d.h. die Nut) eingreifen und mit den Luftpolstern der Führungsluftlager 8 entlang der Außenseiten dieser Nut gleiten. Das Mittelteil 4 wird mittels eines Antriebselementes (nicht dargestellt) verfahren.

Über dem Mitteil 4 ist ein ebenfalls mit einer innenliegenden Öffnung 18 ausgebildeter Tischkörper 5 angeordnet. Er ist auf Tragluftlagern 7 auf der Oberfläche des Granitblocks 19 gleitend verfahrbar. Der Tischkörper 5 wird in y-Richtung mittels eines Antriebselementes (nicht dargestellt) verfahren. Um eine sicher Führung in der y-Richtung zu erzielen, wird der Tischkörper 5 entlang des y-Führungselementes 6 geführt. Dazu sind mit dem Tischkörper 5 Halteelemente 14 fest verbunden, an denen ein y-Lineal 15 oberhalb des y-Führungselementes 6 befestigt ist. Dieses y-Lineal 15 überspannt das y-Führungselement 6 und weist an seinen Außenseiten mehrere Führungsluftlager 8 auf. Die Führungsluftlager 8 gleiten mit ihren Luftpolstern entlang der Außenseiten des y-Führungselementes 6 und stellen damit eine exakte Führung in y-Richtung sicher.

In x-Richtung folgt der Tischkörper 5 zwangsweise der Bewegung des Mittelteils 4 in x-Richtung. Auf diese Weise kann der Tischkörper 5 beliebige Positionen in der x- und der y-Richtung einnehmen. Die Position des Tischkörpers 5 wird mit je einem Laser-Interferometer-System 21 (nur eines dargestellt) in x- und y-Richtung gemessen .

Auf den Tischkörper 5 ist eine Maske 22 aufgelegt. Die Maske 22 besteht z.B. aus Quarzglas. Auf der Maskenoberfläche sind Strukturen 23 aufgebracht. Da der Granitblock 19 (d.h. das Basisteil), das Mittelteil 4 und der Tischkörper 5 als Rahmen ausgebildet sind, kann die Maske 22 durch die innenliegenden Öffnungen 18 auch von unten her durchleuchtet werden.

Oberhalb der Maske 22 befindet sich als Abbildungssystem ein Objektiv 24 hoher optischer Güte, das zur Fokussierung längs seiner optischen Achse 25 in z-Richtung verstellbar ist. Über einen Teilerspiegel 26 wird zum einen das Licht einer Auflicht-Lichtquelle 27 in den optischen Strahlengang eingeleitet und zum anderen werden die Abbildungsstrahlen auf eine Detektor-Einrichtung 28 gelenkt. Die Detektor-Einrichtung 28 ist z. B. eine CCD-Kamera mit hochauflösendem Pixelarray oder ein anderer ortsauflösender Detektor. Die Auflicht-Lichtquelle 27 emittiert beispielsweise im nahen UV-Spektralbereich. Mittels der Detektor-Einrichtung 28 wird die Position einer Struktur 23 als Koordinaten auf der Maske 22 bestimmt. Die Bestimmung der Koordinaten erfolgt dabei üblicherweise relativ zu einem Bezugspunkt.

Innerhalb und unterhalb des Granitblocks 19 ist als weitere Beleuchtungseinrichtung eine Durchlicht-Beleuchtungseinrichtung mit einem höhenverstellbaren Kondensor 29 und einer Durchlicht-Lichtquelle 30 eingesetzt. Von der Durchlicht-Lichtquelle 30 geht ein Durchlicht-Beleuchtungsstrahlengang mit einer optischen Achse 25 aus. Das Licht der Durchlicht-Lichtquelle 30 wird über eine vergrößernde Einkoppeloptik 31 mit möglichst großer Numerischer Eintrittsapertur (z.B. von NA = 0.60) abgenommen. Das abgenommene Licht wird mit der Einkoppeloptik 31 in einen Lichtwellenleiter 32 eingekoppelt. Eine Auskoppeloptik 33, die vorzugsweise als ein Achromat ausgebildet ist, kollimiert das von dem Lichtwellenleiter 32 emittierte Licht.

Die optische Achse des Kondensors 29 fluchtet mit der optischen Achse 25 des Objektivs 24. Die Höhenverstellung des Kondensors 29 dient der Anpassung der auf die Struktur 23 zu richtenden Beleuchtungsstrahlen an Masken 22 mit unterschiedlichen optischen Dicken. Der Kondensorkopf kann, wie hier dargestellt, insbesondere in die innenliegendende Öffnung des Messtischrahmens hineinreichen. Bei xy-Verschiebungen des Tischkörpers 5 über die gesamte Maskenfläche kann der Kondensor 29 zum Schutz vor Beschädigungen aber auch unter die Oberfläche des Granitblocks 19 gezogen werden. Die Lichtquellen 30 und 27 sind voneinander unabhängig einschaltbar. Dadurch ist einzeln oder abwechselnd eine Messung mit Auflichtbeleuchtung und Durchlichtbeleuchtung möglich.

Die vorliegende Erfindung ist in Bezug auf Ausführungsbeispiele beschrieben worden. Es ist jedoch für jeden auf diesem Fachgebiet tätigen Fachmann offensichtlich, dass Änderungen und Abwandlungen vorgenommen werden können, ohne dabei den Schutzbereich der nachstehenden Ansprüche zu verlassen.

### Bezugszeichenliste

- 1: Koordinaten-Messtisch
- 2: Basisteil
- 3: x-Führungselement
- 4: Mittelteil
- 4a,b: Mittelteil-Seitenelement
- 4c: Abstandselement
- 4d: Aussparungen
- 4e: Montagefläche für Führungsluftlager
- 5: Tischkörper
- 6: y-Führungselement
- 7: Tragluftlager
- 8: Führungsluftlager
- 8a: Austrittsöffnungen
- 8b: Montagefläche am Führungsluftlager
- 9: erstes Antriebselement
- 10: erste Schubstange
- 11: zweites Antriebselement
- 12: zweite Schubstange
- 13: zusätzliches Tragelement
- 14: Halteelemente
- 15: y-Lineal
- 15a: Montageflächen
- 16: Ringluftlager
- 17: Schubstange
- 18: innen liegende Öffnung
- 19: Granitblock
- 20: Schwingungsdämpfer
- 21: Laser-Interferometer-System
- 22: Maske
- 23: Strukturen
- 24: Objektiv
- 25: optische Achse
- 26: Teilerspiegel
- 27: Auflicht-Lichtquelle
- 28: Detektor-Einrichtung
- 29: Kondensor
- 30: Durchlicht-Lichtquelle
- 31: Einkoppeloptik
- 32: Lichtwellenleiter
- 33: Auskoppeloptik

## Patentansprüche

1. Koordinaten-Messtisch (1) mit interferometrischer Positionsbestimmung, der übereinander angeordnet folgende Elemente aufweist:
- ein feststehendes Basisteil (2) mit einem linearen x-Führungselement (3),
- darüber ein entlang des linearen x-Führungselements (3) gleitend bewegliches Mittelteil (4), dem ein erstes Antriebselement (9) zugeordnet ist und das mit einem linearen y-Führungselement (6) starr verbunden ist,
- darüber einen xy-positionierbaren, entlang des y-Führungselements (6) gleitend beweglichen Tischkörper (5) zur Aufnahme eines Substrates, dem ein zweites Antriebselement (11) zugeordnet ist,
**dadurch gekennzeichnet**,
a) dass das Mittelteil (4) über dem Basisteil (2) frei hängend angeordnet ist, wobei es sich mit seinem einen Ende auf das y-Führungselement (6) und mit seinem anderen Ende auf ein zusätzlich angeordnetes Tragelement (13) abstützt,
b) dass das y-Führungselement (6), das Tragelement (13) und der Tischkörper (5) sich unabhängig von einander gleitbar auf die Oberfläche des Basisteils (2) abstützen
c) dass das Basisteil (2), das Mittelteil (4) und der Tischkörper (5) jeweils eine innenliegende Öffnung (18) für einen Durchlichtbereich aufweisen.

2. Koordinaten-Messtisch (1) nach Anspruch 1, **dadurch gekennzeichnet, dass** das erste Antriebselement und das zweite Antriebselement relativ zu dem Basisteil (2) ortsfest angeordnet sind.

3. Koordinaten-Messtisch (1) nach Anspruch 1, **dadurch gekennzeichnet, dass** unter dem Tischkörper (5), dem y-Führungselement (6) und dem Tragelement (13) mehrere Tragluftlager (7) angeordnet sind, mit denen diese sich auf das Basisteil (2) abstützen.

4. Koordinaten-Messtisch (1) nach Anspruch 3, **dadurch gekennzeichnet, dass** das Mittelteil (4) aus zwei seitlichen Mittelteil-Seitenelementen (4a, 4b) und mindestens einem zwischen den beiden Mittelteil-Seitenelementen (4a, 4b) angeordneten Abstandselement (4c) besteht und dass an den Mittelteil-Seitenelementen (4a, 4b) mehrere Führungsluftlager (8) angeordnet sind, die gegen das x-Führungselement (3) gelagert sind und die x-Bewegung des Mittelteils (4) führen.

5. Koordinaten-Messtisch (1) nach Anspruch 4, **dadurch gekennzeichnet, dass** die Führungsluftlager (8) hochebene Montageflächen (8b) aufweisen und mit diesen an dafür vorgesehenen, ebenfalls hochebenen Montageflächen (4f) der Mittelteil-Seitenelemente (4a, 4b) befestigt sind, wobei die Breite der Luftspalte der Führungsluftlager (8) unveränderlich vorgegeben ist durch die Differenz der Breite des x-Führungselementes (3) und der Breite des Abstandselementes (4c).

6. Koordinaten-Messtisch (1) nach Anspruch 4, **dadurch gekennzeichnet, dass** das Basisteil (2) und das Abstandselement (4c) im wesentlichen denselben Ausdehnungskoeffizienten aufweisen.

7. Koordinaten-Messtisch (1) nach Anspruch 1, **dadurch gekennzeichnet, dass** an dem Tischkörper (5) direkt oder mittels eines Halteelementes (14) ein y-Lineal (15) angeordnet ist und dass an dem y-Lineal (15) mehrere Führungsluftlager (8) angebracht sind, welche gegen das y-Führungselement (6) gelagert sind und die y-Bewegung des Tischkörpers (5) führen,
und dass die Führungsluftlager (8) hochebene Montageflächen (8b) aufweisen und mit diesen an dafür vorgesehenen, ebenfalls hochebenen Montageflächen (15a) des y-Lineals (15) befestigt sind, wobei die Breite der Luftspalte der Führungsluftlager (8) unveränderlich vorgegeben ist durch die Differenz der Breite des y-Führungselementes (3) und der Breite des y-Lineals (15).

8. Koordinaten-Messtisch (1) nach Anspruch 7, **dadurch gekennzeichnet, dass** das y-Lineal (15) und das y-Führungselement (6) im wesentlichen denselben Ausdehnungskoeffizienten aufweisen.

9. Koordinaten-Messgerät zur hochgenauen Messung der Koordinaten einer Kante eines Strukturelementes (23) auf einem Substrat (22) mit
- einem xy-verfahrbaren Koordinaten-Messtisch (1) mit interferometrischer Positionsbestimmung, der ein feststehendes Basisteil (2) mit einem linearen x-Führungselement (3), darüber ein entlang des linearen x-Führungselements (3) gleitend bewegliches Mittelteil (4) und darüber einen xy-positionierbaren, entlang des y-Führungselements (6) gleitend beweglichen Tischkörper (5) zur Aufnahme des Substrats aufweist ,
- sowie einer Beleuchtungseinrichtung mit einer optischen Achse (25), einer Abbildungseinrichtung (24) und einer Detektor-Einrichtung (28) zur Bestimmung der Koordinaten der zu messenden Kante relativ zur der optischen Achse (25) der Beleuchtungseinrichtung,
**dadurch gekennzeichnet, dass**
a) dass das Mittelteil (4) über dem Basisteil (2) frei hängend angeordnet ist, wobei es sich mit seinem einen Ende auf das y-Führungselement (6) und mit seinem anderen Ende auf ein zusätzlich angeordnetes Tragelement (13) abstützt,
b) dass das y-Führungselement (6), das Tragelement (13) und der Tischkörper (5) sich unabhängig von einander gleitbar auf die Oberfläche des Basisteils (2) abstützen,
c) dass das Basisteil (2), das Mittelteil (4) und der Tischkörper (5) des Messtischs jeweils eine innenliegende Öffnung (18) für einen Durchlichtbereich aufweisen und die Beleuchtungseinrichtung für Auf-und Durchlicht-Beleuchtung des Substrates (22) vorgesehen ist.

10. Koordinaten-Messgerät nach Anspruch 9,
**dadurch gekennzeichnet, dass** dass dem Mittelteil (4) des Messtisches ein erstes Antriebselement (9) und dem Tischkörper (5) des Messtisches ein zweites Antriebselement (11) zugeordnet ist und dass das erste Antriebselement und das zweite Antriebselement relativ zu dem Basisteil (2) des Messtisches ortsfest angeordnet sind.

## Claims

1. Coordinate measuring table (1) with interferometric position determination, having the following elements arranged above one another:
- a fixed base part (2) with a linear x-guiding element (3),
- above this, a movable central part (4) capable of sliding along the linear x-guiding element (3), to which movable central part a first driving element (9) is allocated and is rigidly joined to a linear y-guiding element (6),
- above this, an xy-positionable and movable table body (5) capable of sliding along the y-guiding element (6) for the purpose of accommodating a substrate, to which a second drive element (11) is allocated,
**characterised, in that**
a) the central part (4) is arranged in a freely suspended manner over the base part (2), wherein it supports itself with its one end on the y-guiding element (6) and with its other end on an additionally arranged support element (13),
b) the y-guiding element (6), the support element (13) and the table body (5) support themselves, independently of one another and with sliding capability on the surface of the base part (2),
c) the base part (2), the central part (4) and the table body (5) each have an internally located opening (18) for a transillumination zone.

2. Coordinate measuring table (1) according to Claim 1, **characterised in that** the first driving element and the second driving element are arranged in a stationary position relative to the base part (2).

3. Coordinate measuring table (1) according to Claim 1, **characterised in that**, underneath the table body (5), the y-guiding element (6) and the support element (13), several supporting air bearings (7) are arranged, with which these support themselves on the base part (2).

4. Coordinate measuring table (1) according to Claim 3, **characterised in that** the central part (4) consists of two lateral central part side elements (4a, 4b) and at least one clearance element (4c) arranged between the two central part side elements (4a, 4b), and that several guide air bearings (8) are arranged at the central part side elements (4a, 4b) where said bearings (8) are supported against the x-guiding element (3) and guide the x-movement of the central part (4).

5. Coordinate measuring table (1) according to Claim 4, **characterised in that** the guide air bearings (8) have high-level assembly surfaces (8b) and, with these, are secured to assembly surfaces (4f) of the central part side elements (4a, 4b), envisaged for this purpose, which are also high-level surfaces, the width of the air gap of the guide air bearings (8) being unchangeably set by the difference of the width of the x-guiding element (3) and the width of the clearance element (4c).

6. Coordinate measuring table (1) according to Claim 4, **characterised in that** the base part (2) and the clearance element (4c) essentially have the same expansion coefficient.

7. Coordinate measuring table (1) according to Claim 1, **characterised in that** a y-straightedge (15) is arranged at the table body, either directly or by means of a holding element (14), and that several guide air bearings (8) are attached to the y-straightedge (15), which are supported against the y-guiding element (6) and guide the y-movement of the table body (5),
and that the guide air bearings (8) have high-level assembly surfaces (8b) and, with these, are secured to assembly surfaces (15a) of the y-straightedge (15), envisaged for this purpose, which are also high-level surfaces, the width of the air gap of the guide air bearings (8) being unchangeably set by the difference of the width of the y-guiding element (6) and the width of the y-straightedge (15).

8. Coordinate measuring table (1) according to Claim 7, **characterised in that** the y-straightedge (15) and the y-guiding element (6) have essentially the same expansion coefficient.

9. Coordinate measuring device for the high-precision measurement of the coordinates of an edge of a structure element (23) on a substrate (22) with
- an xy-movable coordinate measuring table (1) with interferometric position determination having a fixed base part (2) with a linear x-guiding element (3), above this a movable central part (4) capable of sliding along the linear x-guiding element (3), and above this an xy-positionable table body (5) capable of sliding along the linear y-guiding element (6) for the purpose of accommodating the substrate,
- and an lighting equipment with an optical axis (25), an imaging equipment (24) and a detector equipment (28) for determining the coordinates of the edge to be measured relative to the optical axis (25) of the lighting equipment,
**characterised, in that**
a) the central part (4) is arranged in a freely suspended manner over the base part (2), wherein it supports itself with its one end on the y-guiding element (6) and with its other end on an additionally arranged support element (13),
b) the y-guiding element (6), the support element (13) and the table body (5) support themselves independently of one another slidably on the surface of the base part (2),
c) the base part (2), the central part (4) and the table body (5) of the measuring table each have an internally located opening (18) for a transillumination zone and the lighting equipment is envisaged for vertical illumination and transillumination of the substrate (22).

10. Coordinate measuring device according to Claim 9,
**characterised, in that** a first drive element (9) is allocated to the central part (4) of the measuring table, and a second drive element (11) is allocated to the table body (5) of the measuring table, and that the first drive element and the second drive element are arranged in a stationary position relative to the base part (2) of the measuring table.

## Revendications

1. Table de mesure de coordonnées (1) avec détermination de position interférométrique qui présente les éléments suivants disposés l'un au-dessus de l'autre :
- une partie de base (2) fixe avec un élément de guidage sur l'axe x (3) linéaire,
- au-dessus de cette dernière, une partie centrale (4) mobile se déplaçant par glissement le long de l'élément de guidage sur l'axe x (3) linéaire, partie centrale à laquelle est affectée un premier élément d'entraînement (9) et qui est reliée de manière rigide à un élément de guidage sur l'axe y (6) linéaire,
- au-dessus de cette dernière, un corps de table (5) mobile pouvant être positionné sur le plan xy et se déplaçant par glissement le long de l'élément de guidage sur l'axe y (6) pour le logement d'un substrat, corps auquel est affecté un deuxième élément d'entraînement (11),
**caractérisée en ce que**
a) la partie centrale (4) est disposée en suspension libre au-dessus de la partie de base (2), étant donné qu'elle s'appuie avec l'une de ses extrémités sur l'élément de guidage sur l'axe y (6) et avec son autre extrémité sur un élément de support (13) additionnellement disposé,
b) l'élément de guidage sur l'axe y (6), l'élément de support (13) et le corps de table (5) s'appuient indépendamment l'un de l'autre de manière coulissante sur la surface de la partie de base (2),
c) la partie de base (2), la partie centrale (4) et le corps de table (5) présentent chacun une ouverture intérieure (18) pour une zone d'éclairage par transmission.

2. Table de mesure de coordonnées (1) selon la revendication 1, **caractérisée en ce que** le premier élément d'entraînement et le deuxième élément d'entraînement sont disposés à une position fixe par rapport à la partie de base (2).

3. Table de mesure de coordonnées (1) selon la revendication 1, **caractérisée en ce que** sont disposés sous le corps de table (5), l'élément de guidage sur l'axe y (6) et l'élément de support (13) plusieurs paliers à air porteurs (7) avec lesquels ces derniers s'appuient sur la partie de base (2).

4. Table de mesure de coordonnées (1) selon la revendication 3, **caractérisée en ce que** la partie centrale (4) se compose de deux éléments de côté de partie centrale latéraux (4a, 4b) et d'au moins un élément d'écartement (4c) disposé entre les deux éléments de côté de partie centrale latéraux (4a, 4b) et que sont disposés sur les deux éléments de côté de partie centrale latéraux (4a, 4b) plusieurs paliers à air de guidage (8) qui sont logés contre l'élément de guidage sur l'axe x (3) et conduisent le mouvement de la partie centrale (4) sur l'axe x.

5. Table de mesure de coordonnées (1) selon la revendication 4, **caractérisée en ce que** les paliers à air de guidage (8) présentent des surfaces de montage (8b) très planes et sont fixés avec ces dernières sur les surfaces de montage (4f) également très planes des éléments de côté de partie centrale latéraux (4a, 4b) prévues à cet effet, étant donné que la largeur des entrefers des paliers à air de guidage (8) est invariable et prescrite par la différence de largeur de l'élément de guidage sur l'axe x (3) par rapport à la largeur de l'élément d'écartement (4c).

6. Table de mesure de coordonnées (1) selon la revendication 4, **caractérisée en ce que** la partie de base (2) et l'élément d'écartement (4c) ont essentiellement le même coefficient de dilatation.

7. Table de mesure de coordonnées (1) selon la revendication 1, **caractérisée en ce que** est disposée sur le corps de table (5), directement ou au moyen d'un élément de retenue (14), une règle y (15) et que sont installés sur la règle y (15) plusieurs paliers à air de guidage (8) qui sont logés contre l'élément de guidage sur l'axe y (6) et conduisent le mouvement du corps de table (5) sur l'axe y,
et **en ce que** les paliers à air de guidage (8) présentent des surfaces de montage (8b) très planes et sont fixés avec ces dernières sur des surfaces de montage (15a) également très planes de la règle y (15) prévues à cet effet, étant donné que la largeur des entrefers des paliers à air de guidage (8) est invariable et prescrite par la différence de largeur de l'élément de guidage sur l'axe y (6) par rapport à la largeur de la règle y (15).

8. Table de mesure de coordonnées (1) selon la revendication 7, **caractérisée en ce que** la règle y (15) et l'élément de guidage sur l'axe y (6) ont essentiellement le même coefficient de dilatation.

9. Machine de mesure de coordonnées pour la mesure hautement précise des coordonnées d'une arête d'un élément de structure (23) sur un substrat (22) avec
- une table de mesure de coordonnées (1) avec détermination de position interférométrique pouvant être déplacée dans le plan xy, table qui présente une partie de base (2) fixe avec un élément de guidage sur le plan x (3), au-dessus de ce dernier une partie centrale (4) mobile se déplaçant par glissement le long de l'élément de guidage sur l'axe x (3) linéaire et au-dessus de cette dernière un corps de table (5) mobile pouvant être positionné sur le plan xy et se déplaçant par glissement le long de l'élément de guidage sur l'axe y (6) pour le logement du substrat,
- ainsi qu'un équipementn d'éclairage avec un axe optique (25), un équipement de représentation (24) et un équipement détecteur (28) pour la détermination des coordonnées de l'arête à mesure par rapport à l'axe optique (25) de l'équipement d'éclairage,
**caractérisée en ce que**
a) la partie centrale (4) est disposée en suspension libre au-dessus de la partie de base (2), étant donné qu'elle s'appuie avec l'une de ses extrémités sur l'élément de guidage sur l'axe y (6) et avec son autre extrémité sur un élément de support (13) additionnellement disposé,
b) l'élément de guidage sur l'axe y (6), l'élément de support (13) et le corps de table (5) s'appuient indépendamment l'un de l'autre de manière coulissante sur la surface de la partie de base (2),
c) la partie de base (2), la partie centrale (4) et le corps de table (5) présentent chacun une ouverture intérieure (18) pour une zone d'éclairage par transmission et l'équipement d'éclairage est prévu pour l'éclairage par lumière incidente et par transmission du substrat (22).

10. Machine de mesure de coordonnées selon la revendication 9, **caractérisée en ce que** est affectée à la partie centrale (4) de la table de mesure un premier élément d'entraînement (9) et au corps de table (5) de la table de mesure est affecté un deuxième élément d'entraînement (11) et **en ce que** le premier élément d'entraînement et le deuxième élément d'entraînement sont disposés à une position fixe par rapport à la partie de base (2).
